# DEMANDE DE BREVET EUROPEEN

(11) **EP 3 258 505 A1**
(43) Date de publication de la demande: **20.12.2017**
(21) Numéro de dépôt: 17175619.0
(22) Date de dépôt: 13.06.2017
(51) Int. Cl.: H01L 31/068, H01L 21/223, H01L 31/18

(54) **PROCÉDÉ DE DOPAGE MONO-FACIAL DE PLAQUETTES EN SILICIUM**

(30) Priorité: 17.06.2016 FR 1655672
(71) Demandeur: Commissariat à l'Energie Atomique et aux Energies Alternatives, 75015 Paris (FR)
(72) Inventeur: LIGNIER, Hélène, 38380 Saint Laurent Du Pont (FR); CASCANT-LOPEZ, Miguel, 46183 L'eliana (Valencia) (ES); DUBOIS, Sébastien, 74950 Scionzier (FR); MONNA, Rémi, 68640 Muespach Le Haut (FR)
(74) Mandataire: Cabinet Camus Lebkiri

(57) **Abrégé**

L'invention concerne un procédé de dopage de plaquettes de silicium (100) présentant chacune une face avant et une face arrière, comprenant les étapes suivantes :
- disposer les plaquettes de silicium dans une nacelle en apposant leur face arrière contre une surface plane ;
- introduire la nacelle dans un four de diffusion ;
- introduire dans le four de diffusion de l'oxygène et des impuretés dopantes d'un premier type de conductivité et diffuser thermiquement les impuretés dopantes en surface des plaquettes de silicium, d'où il résulte une première couche de silicium (101a), dopée du premier type de conductivité et occupant toute la face avant (100a) de chaque plaquette de silicium, et une deuxième couche de silicium (101b), dopée du premier type de conductivité et située en périphérie de la face arrière (100b) de chaque plaquette de silicium, les première et deuxième couches de silicium étant recouvertes respectivement d'une première (102a) et d'une deuxième (102b) couches en oxyde de silicium dopé ;
- plonger (S2) les plaquettes de silicium (100) dans une solution alcaline (300), de façon à graver les première et deuxième couches (102a, 102b) en oxyde de silicium dopé et la deuxième couche de silicium (101b).

## Description

### DOMAINE TECHNIQUE

La présente invention est relative aux techniques de dopage par diffusion de plaquettes de silicium, destinées notamment à l'industrie photovoltaïque. L'invention concerne plus particulièrement un procédé permettant de ne doper qu'une seule face des plaquettes de silicium.

### ÉTAT DE LA TECHNIQUE

La réalisation de cellules photovoltaïques à base de silicium requiert une étape de dopage des plaquettes de silicium, afin de créer une jonction p-n. Ce dopage est le plus souvent obtenu par la diffusion thermique d'atomes de phosphore (dans le cas d'un dopage de type n) ou d'atomes de bore (dopage de type p) en surface des plaquettes. De façon classique, la diffusion des dopants s'effectue dans un four dont l'enceinte est formée d'un tube en quartz. Ce tube contient un ou plusieurs supports, appelés nacelles, dans lesquels les plaquettes de silicium sont disposées. Les dopants proviennent d'une source, qui peut être solide, liquide ou gazeuse selon la nature de l'élément dopant (B, P, As, Sb...) et le profil de dopage recherché.

Le dopage des plaquettes dans le four de diffusion s'effectue généralement en deux temps. Dans un premier temps, les plaquettes sont maintenues dans l'enceinte du four, saturée par les dopants sous une forme gazeuse, dans des conditions de pression et de température données. Les dopants se déposent sur la surface des plaquettes pour former une couche riche en dopants, typiquement un verre de silicate dopé au phosphore (PSG, pour « phosphosilicate glass » en anglais) ou au bore (BSG, pour « borosilicate glass »). Puis, dans un deuxième temps, les plaquettes sont portées à plus haute température afin de faire diffuser les dopants de la couche de PSG (ou BSG) vers le silicium.

Un four de diffusion peut accueillir dans le tube en quartz un grand nombre de plaquettes, ce qui permet d'augmenter la cadence de production et de réduire le coût de l'étape de dopage dans la fabrication d'une cellule photovoltaïque. À cet effet, les nacelles présentent une multitude de fentes réceptrices dans lesquelles sont réparties les plaquettes de silicium, à raison d'une plaquette par fente. Les faces avant et arrière des plaquettes de silicium sont exposées simultanément aux dopants, car les plaquettes reposent sur la tranche dans les fentes réceptrices.

De nombreuses architectures de cellules photovoltaïques requièrent de ne doper qu'une seule face des plaquettes de silicium avec un type de dopants donné. Par exemple, pour des cellules à architecture standard formées à partir de plaquettes en silicium cristallin dopé de type p, seule la face avant des plaquettes est dopée de type n pour former l'émetteur de la jonction p-n (le substrat de type p formant la base de la jonction).

Pour éviter qu'un dopage par diffusion n'affecte simultanément les deux faces d'une plaquette, une solution classique consiste à couvrir d'un masque l'une des deux faces, la face arrière dans l'exemple précédent d'une cellule photovoltaïque à émetteur en face avant. Le masque constitue une couche barrière à la diffusion des dopants dans le silicium de la plaquette. Ce masque est généralement constitué de nitrure de silicium (SiN), obtenu par dépôt chimique en phase vapeur assisté par plasma (ou PECVD, pour « Plasma-Enhanced Chemical Vapor Deposition » en anglais), d'un oxyde de silicium thermique ou d'une couche diélectrique déposée dans des conditions de vide poussé. La formation du masque et son retrait après l'étape de diffusion constituent des étapes additionnelles, souvent coûteuses (PECVD et dépôt sous vide notamment), qui s'ajoutent à l'étape de gravure du verre de silicate en face avant. La solution classique engendre par conséquent une augmentation du coût de production de la cellule photovoltaïque.

La demande internationale de brevet WO2012/127123 divulgue un procédé de dopage par diffusion ayant pour but de réduire le coût de traitement d'une plaquette de silicium. Dans ce procédé, les plaquettes de silicium sont disposées dos-à-dos dans leur support, c'est-à-dire face arrière contre face arrière. Les fentes réceptrices des nacelles ont une largeur au moins égale à deux fois l'épaisseur des plaquettes de silicium. Dans le four de diffusion, les plaquettes sont orientées horizontalement plutôt que verticalement. Ainsi, le poids de la plaquette supérieure assure un meilleur contact entre les faces arrière des deux plaquettes.

Ce procédé de dopage n'est toutefois pas satisfaisant car une diffusion résiduelle est observée sur les bords des faces arrière des deux plaquettes. Cette diffusion résiduelle est due au fait que le contact entre les deux plaquettes ne s'étend pas sur toute la superficie de leur face arrière (les plaquettes n'étant jamais totalement planes). La face arrière des plaquettes traitées selon ce procédé est donc partiellement dopée du même type que la face avant (et les tranches), ce qui est préjudiciable pour le fonctionnement des cellules photovoltaïques.

### RÉSUMÉ DE L'INVENTION

Il existe donc un besoin de prévoir un procédé de dopage de plaquettes de silicium, ayant un faible coût de mise en oeuvre, à l'issue duquel une seule face des plaquettes présente une couche dopée d'un premier type de conductivité. Les plaquettes de silicium ayant deux faces principales opposées, une face avant (ou frontale) et une face arrière (ou dorsale), on désignera ci-après la face dopée du premier type de conductivité comme étant la face avant et la face non dopée (du premier type de conductivité) comme étant la face arrière.

Selon l'invention, on tend à satisfaire ce besoin en prévoyant les étapes suivantes :
- disposer les plaquettes de silicium dans une nacelle en apposant leur face arrière contre une surface plane ;
- introduire la nacelle dans un four de diffusion ;
- introduire dans le four de diffusion de l'oxygène et des impuretés dopantes d'un premier type de conductivité et diffuser thermiquement les impuretés dopantes en surface des plaquettes de silicium, d'où il résulte une première couche de silicium, dopée du premier type de conductivité et occupant toute la face avant de chaque plaquette de silicium, et une deuxième couche de silicium, dopée du premier type de conductivité et située en périphérie de la face arrière de chaque plaquette de silicium, les première et deuxième couches de silicium étant recouvertes respectivement d'une première et d'une deuxième couches en oxyde de silicium dopé ;
- plonger les plaquettes de silicium dans une solution alcaline, de façon à graver les première et deuxième couches en oxyde de silicium dopé et la deuxième couche de silicium.

Par « oxyde de silicium », on désigne un composé contenant du silicium et de l'oxygène, obtenu par la réaction entre l'oxygène introduit dans le four et le silicium des plaquettes. Cet oxyde est dopé car il incorpore les impuretés dopantes présentes dans le four pendant la réaction.

Comme la face arrière des plaquettes de silicium repose contre une surface plane pendant l'étape de diffusion des dopants, seule une portion périphérique de la face arrière est dopée et recouverte de la deuxième couche en oxyde de silicium dopé. Cette deuxième couche d'oxyde est d'épaisseur variable et n'occupe qu'une partie de la face arrière, contrairement à la première couche d'oxyde située en face avant des plaquettes de silicium.

La solution alcaline permet de graver la portion périphérique de silicium dopé et la deuxième couche d'oxyde plus rapidement que la première couche d'oxyde, située en face avant des plaquettes. Cela est possible d'une part grâce à la non-uniformité de la deuxième couche d'oxyde et à un effet de soulèvement (ou effet « lift-off ») de la deuxième couche d'oxyde, causé par une gravure latérale du silicium plus rapide que la gravure verticale de l'oxyde. La première couche de silicium dopé située sous la première couche d'oxyde en face avant des plaquettes peut ainsi être laissée intacte ou n'être gravée que superficiellement.

Un grand nombre de plaquettes peuvent être plongées simultanément dans la solution alcaline. Cette étape de gravure humide est une donc une solution efficace et économique pour limiter le dopage par diffusion à une seule face des plaquettes de silicium.

L'oxyde de silicium dopé est de préférence un verre silicate dopé, par exemple au phosphore (PSG, pour « phosphosilicate glass ») ou au bore (BSG, pour « borosilicate glass »).

De préférence, la gravure des première et deuxième couches en oxyde de silicium dopé et de la deuxième couche de silicium est effectuée dans des conditions telles que le rapport de la cinétique de gravure du silicium sur la cinétique de gravure de l'oxyde de silicium est compris entre 200 et 2000, plus préférentiellement entre 500 et 2000. Ces conditions de gravure précipitent le retrait de la deuxième couche d'oxyde et de la deuxième couche de silicium en face arrière des plaquettes, car l'effet de soulèvement de la deuxième couche d'oxyde est accentué.

Selon un développement du procédé de dopage, la solution alcaline est une solution aqueuse d'hydroxyde alcalin portée à une température comprise entre 0 °C et 80 °C, préférentiellement entre 0 °C et 40 °C, et présentant une concentration pondérale en hydroxyde alcalin comprise entre 5 % à 45 %, préférentiellement entre 10 % et 25 %.

Le procédé selon l'invention peut également présenter une ou plusieurs des caractéristiques ci-dessous, considérées individuellement ou selon toutes les combinaisons techniquement possibles :
- la solution alcaline est choisie parmi une solution aqueuse d'hydroxyde de lithium (LiOH), une solution aqueuse d'hydroxyde de potassium (KOH), une solution aqueuse d'hydroxyde de sodium (NaOH) et une solution aqueuse de tétraméthylammonium hydroxyde (TMAH) ;
- les plaquettes de silicium sont réparties par paire dans des fentes réceptrices de la nacelle, en accolant leurs faces arrière l'une contre l'autre ;
- les plaquettes de silicium sont posées à plat sur une plateforme de la nacelle ; et
- les plaquettes de silicium sont initialement dopées d'un second type de conductivité opposé au premier type de conductivité.

### BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1 représente l'étape de diffusion d'un procédé de dopage selon un mode de mise en oeuvre préférentiel de l'invention ;
- les figures 2A, 2B et 2C illustrent, respectivement en vue de dessus, en coupe transversale et en vue de dessous, une plaquette de silicium immédiatement après l'étape de diffusion ;
- les figures 3A et 3B représentent schématiquement une étape de gravure dans une solution alcaline, d'après le procédé de dopage selon l'invention ;
- la figure 4 représente le rapport des cinétiques de gravure entre le silicium et le dioxyde de silicium en fonction de la concentration en hydroxyde alcalin de la solution alcaline, pour différentes températures de la solution ;
- la figure 5 représente la réflectivité de la face arrière de la plaquette diffusée, avant et après l'étape de gravure alcaline ;
- la figure 6 représente la réflectivité de la face avant de la plaquette diffusée, avant et après l'étape de gravure alcaline ;
- la figure 7 représente des zones de mesure de la concentration en dopants, réparties sur la face et la face arrière d'une plaquette de silicium ;
- la figure 8 représente des profils de la concentration en dopants en face arrière de la plaquette diffusée, avant et après l'étape de gravure alcaline ; et
- la figure 9 représente des profils de la concentration en dopants en face avant de la plaquette diffusée, avant et après l'étape de gravure alcaline

Pour plus de clarté, les éléments identiques ou similaires sont repérés par des signes de référence identiques sur l'ensemble des figures.

### DESCRIPTION DÉTAILLÉE D'AU MOINS UN MODE DE RÉALISATION

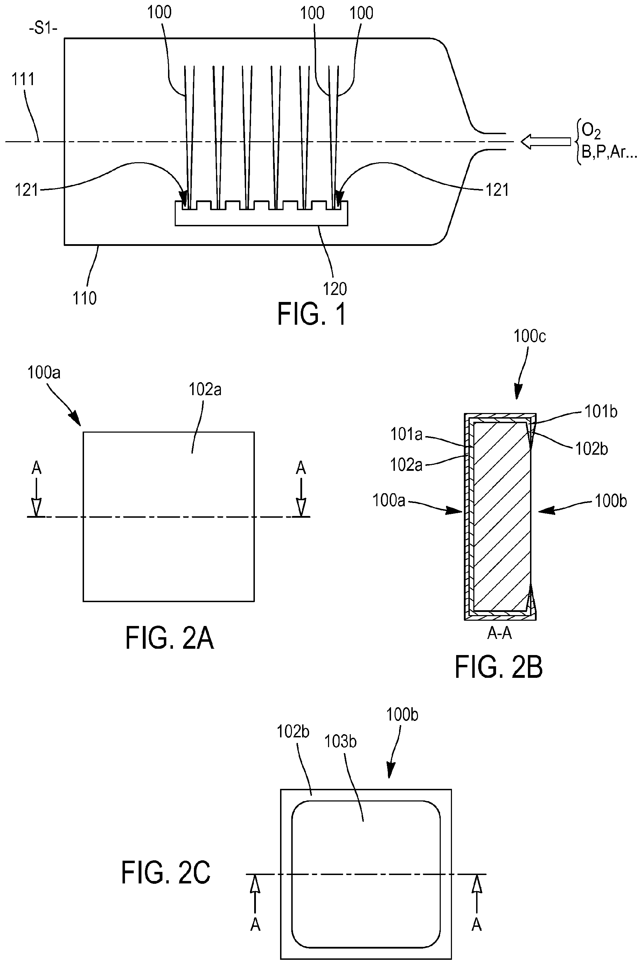

Un mode de mise en oeuvre préférentiel du procédé de dopage mono-facial selon l'invention va maintenant être décrit en référence aux figures 1, 2A-2C et 3A-3B.

Le procédé de dopage comprend une première étape S1, représentée par la figure 1, consistant à introduire des plaquettes de silicium 100 dans un four de diffusion et à diffuser des impuretés dopantes dans le silicium des plaquettes 100. Les impuretés dopantes sont des atomes d'un élément dopant vis-à-vis du silicium, tel que le bore (B), le phosphore (P), l'arsenic (As) et l'antimoine (Sb). Le dopage par diffusion peut être de type n ou de type p, selon le caractère « donneur d'électrons » ou « accepteur d'électrons » de l'élément dopant. Les porteurs de charge, crées par l'introduction des impuretés dopantes dans le silicium, sont des électrons dans le cas d'un dopage de type n (P, As, Sb) ou des trous dans le cas d'un dopage de type p (B).

Le four de diffusion possède une enceinte 110, formée par exemple d'un tube en quartz, dans laquelle sont disposées les plaquettes de silicium 100 à doper. Les plaquettes 100 sont supportées par une nacelle 120, ou casier, et ont leur face arrière en appui contre une surface plane. La face arrière des plaquettes 100 est ainsi protégée en partie de la diffusion des impuretés dopantes. La mise en place des plaquettes 100 dans la nacelle 120 s'effectue à l'extérieur de l'enceinte 110, puis la nacelle 120 est glissée à l'intérieur de l'enceinte 110.

L'enceinte 110 du four de diffusion peut être dimensionnée pour accueillir plusieurs nacelles 120, en enfilade le long de l'axe longitudinal 111 du tube. Chaque nacelle 120 reçoit une pluralité de plaquettes de silicium 100, typiquement entre 100 et 1400 plaquettes.

Dans le mode de mise en oeuvre préférentiel de la figure 1, les plaquettes 100 sont réparties par paire dans des fentes réceptrices 121 de la nacelle 120. Les plaquettes de chaque paire sont accolées l'une contre l'autre, face arrière contre face arrière. Ainsi, les faces arrière des deux plaquettes se protègent mutuellement de la diffusion des impuretés dopantes. Les plaquettes 100 peuvent être orientées verticalement dans leur support, comme cela est représenté sur la figure 1. Elles reposent alors sur la tranche dans les fentes réceptrices 121 de la nacelle 120. Alternativement, les plaquettes 100 peuvent être orientées horizontalement. Les fentes sont alors aménagées dans des parois latérales (non représentées) de la nacelle et tiennent les plaquettes par deux bords opposés (au moins).

Dans une variante de mise en oeuvre non représentée sur les figures, les plaquettes sont posées à plat dans la nacelle. Dans ce cas, la nacelle est dépourvue de fentes réceptrices mais présente une plateforme, contre laquelle la face arrière de chaque plaquette est en appui. De préférence, la nacelle présente plusieurs plateformes superposées pouvant accueillir chacune une ou plusieurs plaquettes de silicium.

Lors du traitement de diffusion, l'enceinte 110 est parcourue d'une extrémité à l'autre du tube par un ou plusieurs gaz de traitement. Au moins un de ces gaz transporte les impuretés dopantes jusqu'aux plaquettes 100. Les impuretés dopantes sont de type n ou de type p, selon l'application envisagée. Par exemple, pour la formation d'une jonction p-n en face avant des plaquettes 100, les impuretés dopantes sont d'un premier type de conductivité et le silicium des plaquettes 100 est dopé d'un second type de conductivité, opposé au premier type. Initialement, le silicium des plaquettes 100 peut être intrinsèque plutôt que dopé du second type de conductivité.

Les impuretés dopantes sont obtenues à partir d'une source de dopants, qui peut être sous forme solide, liquide ou gazeuse, et située à l'intérieur ou à l'extérieur de l'enceinte 110. Les sources gazeuses sont des gaz contenant l'élément dopant, tels que l'arsine (AsH₃), la phosphine (PH₃) ou le diborane (B₂H₆). Le gaz dopant est injecté dans l'enceinte 110 du four en combinaison avec de l'oxygène (ex. O₂) et éventuellement un gaz inerte. Les sources liquides sont par exemple le trichlorure de phosphoryle (POCl₃) et le tribromure de bore (BBr₃), tous deux liquides à température ambiante. Un gaz vecteur (ex. N₂) barbote dans le liquide à une température généralement comprise entre 15 °C et 25 °C et s'enrichit en dopants, avant d'être injecté dans le tube en combinaison avec de l'oxygène. Les sources solides sont par exemple des plaquettes en nitrure de bore (BN) ou en pentoxyde de phosphore (P₂O₅). Ces plaquettes dopantes sont disposées dans l'enceinte 110 sur le parcours d'un gaz vecteur, en regard des plaquettes 100 à doper ou directement dans la nacelle 120, en alternance avec les plaquettes 100.

Le traitement de diffusion à l'étape S1 s'effectue en deux temps. Dans un premier temps, les plaquettes sont maintenues dans l'enceinte 110 du four sous un flux d'oxygène et de gaz enrichi(s) en dopants, dans des conditions de pression et de température données. Une couche en oxyde de silicium fortement dopé, par exemple un verre de silicate dopé au phosphore (PSG, pour « phosphosilicate glass ») ou au bore (BSG, pour « borosilicate glass »), est ainsi formée à la surface du silicium exposée aux gaz de traitement. Cette première opération, dite de pré-dépôt, est de préférence effectuée à une température comprise entre 750 °C et 850 °C. Puis, lors d'une deuxième opération appelée recuit de redistribution, les plaquettes sont portées à plus haute température (800 °C-950 °C) sous un flux de gaz inerte (ex. N₂) afin de faire diffuser les dopants de la couche d'oxyde vers le silicium.

Les figures 2A et 2C montrent respectivement la face avant 100a et la face arrière 100b d'une plaquette de silicium 100 immédiatement après le traitement de diffusion. La figure 2B est une vue en coupe transversale de la même plaquette, selon le plan de coupe A-A des figures 2A et 2C.

Comme la face avant 100a des plaquettes de silicium 100 est entièrement libre pendant le traitement de diffusion, on obtient une première couche de silicium 101 a, dopée (de type n ou p, selon la nature de l'élément dopant) et d'épaisseur sensiblement constante, qui occupe toute la face avant 100a (cf. Fig. 2B). Autrement dit, la face avant 100a des plaquettes 100 est dopée de manière uniforme. La première couche de silicium 101 a est entièrement recouverte d'une première couche 102a en oxyde de silicium dopé, lieu de départ de la diffusion des dopants. À l'instar de la première couche de silicium 101 a, l'épaisseur de la première couche d'oxyde 102a est sensiblement identique en tout point de la face avant 100a.

Contrairement à la face avant 100a, la face arrière 100b des plaquettes 100 n'est que partiellement dopée. Une deuxième couche de silicium 101 b, dopée par les mêmes impuretés que la première couche de silicium 101 a, occupe la périphérie de la face arrière 100b, sur approximativement 20 mm de large. La deuxième couche de silicium 101 b est recouverte d'une deuxième couche d'oxyde 102b, formée du même matériau que la première couche d'oxyde 102a. La deuxième couche de silicium 101 b et la deuxième couche d'oxyde 102b ont une épaisseur qui diminue en s'approchant du centre de la face arrière 100b.

Ce dopage résiduel, ou parasite, de la face arrière 100b des plaquettes est dû au fait que le contact entre la face arrière 100b et la surface plane lors du traitement de diffusion n'est pas total. Le contact empêche les gaz de traitement d'atteindre la partie centrale 103b de la face arrière 100b. La partie centrale 103b de la face arrière 100b n'est donc ni diffusée par les impuretés dopantes, ni recouverte d'oxyde (cf. Fig.2C). Par contre, la bordure de la face arrière 100b a été exposée aux gaz de traitement.

La forme périphérique de la deuxième couche de silicium 101 b et de la deuxième couche d'oxyde 102b en face arrière 100b des plaquettes peut être mise en évidence grâce à une cartographie de réflectivité, en choisissant une longueur d'onde d'environ 976 nm.

Comme cela est représenté sur la figure 2B, les tranches 100c des plaquettes 100 sont dopées et recouvertes d'oxyde de la même façon que la face avant 100a, car ces tranches 100c sont également exposées aux gaz de traitement.

Le procédé de dopage comprend ensuite une étape de gravure S2 de la deuxième couche de silicium 101 b et de la deuxième couche d'oxyde 102b, afin de restreindre le dopage à la face avant 100a et aux tranches 100c des plaquettes de silicium.

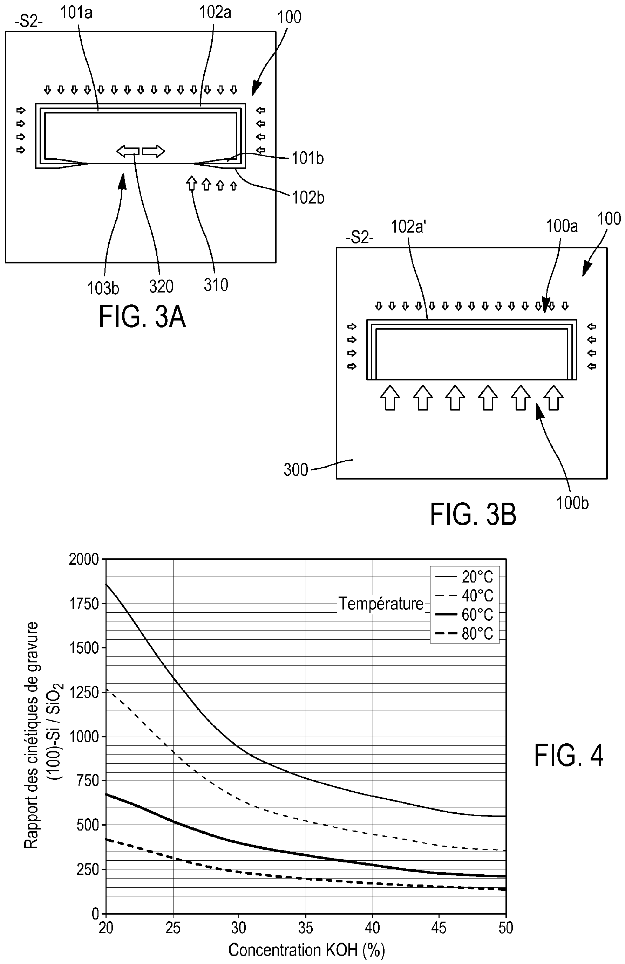

Les figures 3A et 3B illustrent le déroulement de cette étape de gravure S2. Les plaquettes de silicium 100 sont plongées dans une solution alcaline 300. La solution alcaline 300 est de préférence une solution aqueuse d'hydroxyde alcalin (autrement dit, l'eau constitue le solvant de la solution). L'hydroxyde alcalin peut être choisi parmi l'hydroxyde de lithium (LiOH), l'hydroxyde de potassium (KOH), l'hydroxyde de sodium (NaOH) et le tétraméthylammonium hydroxyde (TMAH).

Ce type de solution est connu pour graver plus rapidement le silicium, dopé ou intrinsèque, que le dioxyde de silicium (SiO₂), dopé ou non (l'effet du dopage sur la gravure de ces matériaux étant négligeable). L'oxyde de silicium fortement dopé des couches 102a et 102b étant chimiquement proche du dioxyde de silicium, la solution alcaline 300 présente le même comportement de gravure entre l'oxyde des couches 102a/102b et le silicium dopé des couches 101 a/101 b.

Lorsque les plaquettes 100 sont plongées dans la solution alcaline 300, la deuxième couche d'oxyde 102b située en face arrière est gravée plus rapidement que la première couche d'oxyde 102a située en face avant. Cela est dû au fait qu'une couche périphérique et d'épaisseur variable est gravée plus rapidement qu'une couche « pleine plaque » d'épaisseur constante. En effet, à la gravure verticale 310 de la deuxième couche d'oxyde 102b s'ajoute une gravure latérale 320 de la deuxième couche d'oxyde 102b, accessible latéralement depuis la portion centrale 103b de la face arrière des plaquettes (cf. Fig.3A).

Sur les figures 3A et 3B, on a schématisé la cinétique de gravure par des flèches de taille variable. Plus la cinétique de gravure dans une zone de la plaquette est importante, plus la flèche correspondante située dans la zone est grande. Ici, la cinétique de gravure de la deuxième couche d'oxyde 102b est plus importante lorsque son épaisseur est faible.

La solution alcaline 300 grave également le silicium qui est apparent en face arrière de la plaquette, à un rythme plus élevé que l'oxyde de silicium dopé. La gravure concerne d'abord la portion centrale 103b, puis s'étend en direction des bords de la plaquette jusqu'à la deuxième couche de silicium dopé 101 b. Cette gravure latérale de la deuxième couche de silicium 101 b conduit à un soulèvement de la deuxième couche d'oxyde 102b, ce qui accélère encore son élimination dans la solution alcaline 300. La gravure du silicium par la solution alcaline 300 étant une gravure fortement anisotrope, elle grave le silicium plus vite dans la direction latérale (flèches 320) que dans la direction verticale (flèches 310).

L'épaisseur de la couche de silicium gravée en face arrière de chaque plaquette est de préférence comprise entre 5 nm et 5 µm. Elle dépend de la concentration en hydroxyde alcalin, de la température de la solution et de la durée pendant laquelle les plaquettes sont immergées dans le bain de gravure. Les plaquettes, de forme carrée, pseudo-carrée ou circulaire, ont de préférence une dimension latérale comprise entre 100 mm et 300 mm.

La figure 3B montre un état possible de chaque plaquette de silicium 100 à la fin de l'étape de gravure S2 dans la solution alcaline 300. La deuxième couche de silicium dopé et la deuxième couche d'oxyde, en face arrière 100b de la plaquette, ont été entièrement retirées alors qu'il subsiste une partie 102a' de la première couche d'oxyde. En effet, le temps de gravure est de préférence contrôlé de façon à laisser une fine couche 102a' (1 nm-100 nm) en oxyde de silicium dopé en face avant 100a et sur les tranches 100c de la plaquette. Pour une deuxième couche de silicium dopé 101 b d'épaisseur comprise entre 50 nm et 1 µm, le temps de gravure par la solution alcaline 300 est avantageusement compris entre 15 min et 50 min.

Ainsi, dans un mode de mise en oeuvre de l'étape de gravure S2, la deuxième couche de silicium dopé 101 b et la deuxième couche d'oxyde 102b en face arrière 100b sont retirées en laissant intacte la première couche de silicium dopé 101 a en face avant 100a de la plaquette.

La gravure de la face arrière 100b par la solution alcaline 300 laisse un état de surface « poli miroir », c'est-à-dire de faible rugosité (< 0,2 µm) et de réflectivité élevée (environ 30 %), qui s'avère particulièrement utile dans le cas de cellules photovoltaïques, en technologie PERC (« Passivated Emitter and Rear Cell ») notamment (face arrière réfléchissante). En effet, la surface plane ainsi obtenue possède une meilleure réflectivité qu'une surface texturée, qui pourrait être obtenue par une gravure humide dans un bain d'acide fluorhydrique (HF). Le courant électrique produit par la cellule photovoltaïque sera par conséquent meilleur, car un grand nombre de photons se retrouvera piégé dans la cellule. En outre, la gravure alcaline de la face arrière, fortement basique, produit une passivation de surface (c'est-à-dire que les défauts sont rendus électriquement inactifs). Cette passivation est également bénéfique pour les performances de la cellule. Enfin, le fait d'obtenir une surface plane polie en face arrière des plaquettes facilite la mise en oeuvre des étapes de fabrication ultérieures des cellules photovoltaïques, telles que l'ablation laser mis en oeuvre dans le procédé de fabrication des cellules PERC.

Dans une étape suivante du procédé, la partie restante 102a' de la première couche en oxyde de silicium dopé peut être retirée, de préférence par gravure humide et sélective par rapport au silicium, par exemple dans une solution de HF de concentration comprise entre 2% et 10 % pendant 1 à 15 minutes. Ainsi, la première couche de silicium dopé 101a ne risque pas d'être altérée lors de cette étape de gravure additionnelle.

Les plaquettes 100 peuvent être aussi plongées dans la solution alcaline 300 jusqu'à ce que la première couche d'oxyde 102a en face avant de la plaquette soit entièrement gravée, puis retirées juste après pour ne pas trop consommer la première couche de silicium dopé 101 a. Le temps de gravure correspondant peut être déterminé empiriquement. Une telle variante de mise en oeuvre permet de s'affranchir de l'étape de gravure additionnelle susmentionnée. En outre, une passivation de la face avant est obtenue. En particulier, les atomes inactifs de phosphore ou de bore contenus dans les premiers nanomètres de la couche de silicium dopé 101 a (20-50 nm d'épaisseur) sont éliminés. L'épaisseur de la couche de silicium gravée en face arrière 100b sera par contre plus importante que dans le mode de mise en oeuvre représenté sur la figure 3B.

Le rapport de la cinétique de gravure du silicium sur la cinétique de gravure de l'oxyde de silicium dopé varie en fonction de la température de la solution alcaline et de la concentration pondérale en hydroxyde alcalin. Les conditions de l'étape de gravure S2, en termes de température et de concentration pondérale de la solution alcaline, sont avantageusement choisies de sorte que le rapport de cinétique silicium/oxyde de silicium soit compris entre 200 et 2000, et de préférence entre 500 et 2000. Dans ces conditions de gravure particulières, la cinétique de gravure latérale du silicium est telle que l'effet de soulèvement de la deuxième couche d'oxyde 102b devient prépondérant par rapport aux gravures verticale et latérale de l'oxyde de silicium dopé. Le retrait, total, de la deuxième couche d'oxyde 102b et de la deuxième couche de silicium 101 b se produit alors plus rapidement, ce qui laisse la possibilité de conserver davantage d'oxyde de silicium dopé en face avant. Une couche d'oxyde de silicium dopé en face avant des plaquettes peut servir à lutter contre le phénomène de dégradation sous éclairement des cellules photovoltaïques.

La figure 4 représente à titre d'exemple le rapport de la cinétique de gravure du silicium (d'orientation 100) sur la cinétique de gravure du dioxyde de silicium, en fonction de la concentration pondérale en hydroxyde de potassium (KOH) de la solution alcaline et pour différentes valeur de température comprises entre 20 °C et 80 °C. Bien que ces données concernent le dioxyde de silicium (SiO₂), et non l'oxyde de silicium dopé des couches 102a-102b (ex. PSG et BSG), elles peuvent être utilisées pour déterminer les conditions optimales (température et concentration) de l'étape S2, car les deux oxydes sont proches chimiquement et le comportement de gravure par les ions hydroxyde reste le même.

La figure 4 montre que le rapport des cinétiques de gravure Si/SiO₂ augmente, pour une concentration de KOH donnée, lorsque la température diminue. D'après cette figure, un rapport de cinétiques de gravure silicium/oxyde de silicium entre 200 et 2000 peut être atteint pour une température de solution comprise entre 0 °C et 80 °C et une concentration pondérale en hydroxyde de potassium comprise entre 5 % à 45 %. Plus préférentiellement, la température de la solution est comprise entre 0 °C et 40 °C et la concentration pondérale en hydroxyde de potassium comprise entre 10 % à 25 %

Les conditions optimale de température et de concentration pour d'autres hydroxydes alcalins sont sensiblement les mêmes que celles données ci-dessus pour l'hydroxyde de potassium, puisque les ions hydroxydes sont présents dans les mêmes proportions dans ces solutions. Les plages de valeurs susmentionnées sont donc valables quel que soit l'hydroxyde alcalin.

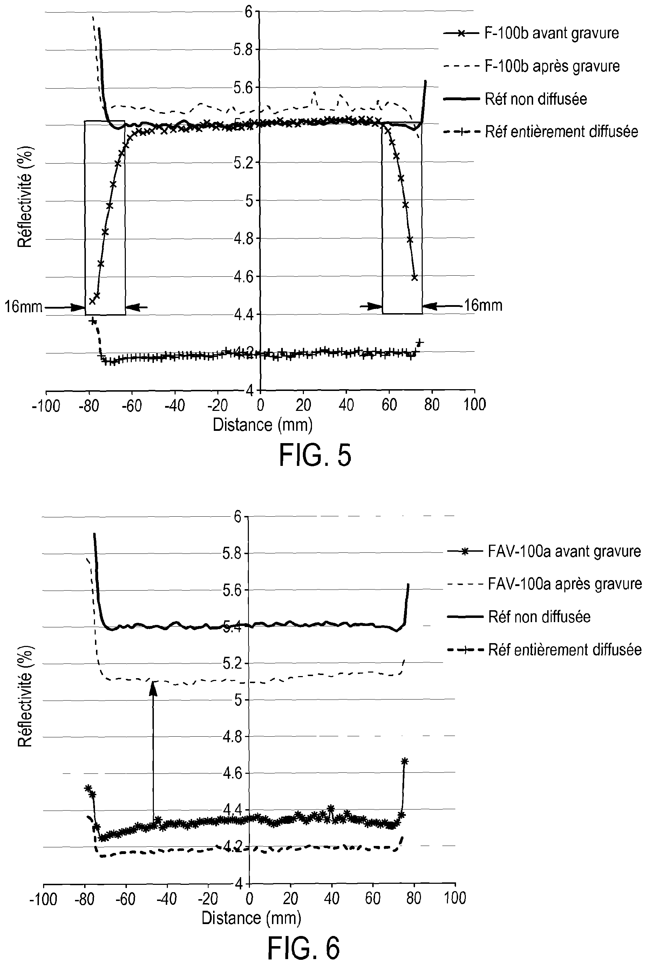

Les figures 5 à 9 démontrent, à travers un exemple de mise en oeuvre, que le procédé de dopage selon l'invention permet amoindrir considérablement, voire de rendre inexistant, le dopage résiduel en périphérie de la face arrière tout en préservant la couche de silicium dopé en face avant des plaquettes de silicium.

Dans cet exemple de mise en oeuvre, un lot de plaquettes de silicium dopées au bore (donc de type p) a été traité conformément aux étapes S1 et S2 décrites ci-dessus. Ces plaquettes, destinées à la fabrication de cellules photovoltaïques, ont une résistivité comprise entre 1 Ω.cm et 3 Ω.cm, une forme carrée (156 mm x 156 mm) et une épaisseur initiale d'environ 180 µm. Avant l'étape S1, les plaquettes ont subi une texturation de surface suivie d'un nettoyage, comme c'est l'usage dans les procédés de fabrication de cellules photovoltaïques. Pendant la diffusion du phosphore (POCl₃ sous forme liquide), les plaquettes du lot sont orientées verticalement et réparties par paire dans les fentes réceptrices de la nacelle. L'étape S2 de gravure est mise en oeuvre en plongeant les plaquettes du lot dans un bain d'hydroxyde de potassium (concentration pondérale en KOH égale 20 %) à une température de 20 °C pendant 15 minutes.

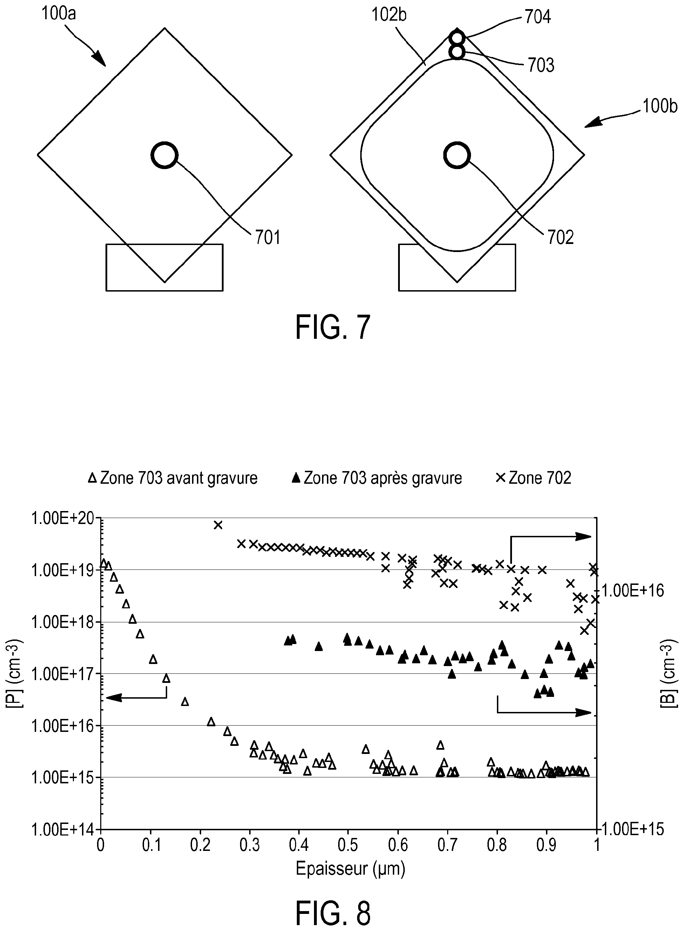

Les plaquettes du lot ont également été caractérisées avant et après l'étape de gravure S2, au niveau de leur face avant et de leur face arrière. Cette caractérisation comprend des mesures de réflectivité (Figs. 5-6) et des mesures de tension-capacité électrochimique (ou ECV, pour « Electrochemical Capacitance Voltage » en anglais), afin de déterminer le profil de dopage (Figs. 8-9). La réflectivité est mesurée, en face avant 100a et en face arrière 100b des plaquettes, le long d'un axe correspondant au plan de coupe A-A de la figure 2A.

La figure 5 est un graphique qui représente la réflectivité mesurée en face arrière 100b de l'une des plaquettes traitées, avant et après la gravure KOH (courbes notées « F-100b avant gravure » et « F-100b après gravure » respectivement). La figure 5 représente également, à titre de comparaison, la réflectivité mesurée sur la face avant d'une première plaquette de référence entièrement diffusée (« Ref entièrement diffusée »), c'est-à-dire disposée seule dans une fente réceptrice de la nacelle, et la réflectivité d'une deuxième plaquette de référence texturée mais non diffusée (« Ref non diffusée »). Le graphique est construit de telle sorte que l'origine des axes correspond au centre des plaquettes (l'axe de mesure de la réflectivité passe par le centre des plaquettes).

La réflectivité de la face arrière 100b avant gravure atteint, aux extrémités latérales gauche et droite de la plaquette traitée, des valeurs proches de celles obtenues pour une plaquette de référence entièrement diffusée. Cela démontre l'existence d'une couche de faible réflectivité, en l'espèce un verre silicate dopé au phosphore (PSG), sur les bords de la face arrière 100b. Cette même réflectivité augmente en s'approchant quelque peu de l'origine du graphique, car l'épaisseur de la couche de PSG diminue en s'approchant du centre de la plaquette. D'après la figure 5, la couche de PSG en face arrière 100b est symétrique par rapport au centre de la plaquette et sa largeur en périphérie de plaquette est d'environ 16 mm.

Grâce aux mesures de la figure 5, on constate en outre que la réflectivité de la face arrière après la gravure KOH (« F-100b après gravure ») est sensiblement la même que celle de la plaquette de référence non diffusée, et donc dépourvue de couche de PSG. Autrement dit, la gravure KOH a permis de retirer quasiment entièrement la couche de PSG située à la périphérie de la face arrière 100b.

La figure 6 est un autre graphique de réflectivité, construit de la même manière que celui de la figure 5. Il représente la réflectivité en face avant d'une plaquette traitée suivant les étapes S1 et S2, la même que sur la figure 5, avant et après la gravure KOH. Les plaquettes de référence sont également les mêmes que sur la figure 5.

On constate d'abord que la réflectivité de la face avant 100a avant la gravure KOH (« F-100a avant gravure ») est très proche de celle de la plaquette de référence entièrement diffusée (4,35 %, contre 4,2 % au centre de la face avant). La faible différence peut être imputée aux erreurs de mesure et aux variabilités du processus de diffusion. Le fait de protéger la face arrière lors de la diffusion n'a donc pas d'impact sur la formation de la couche de PSG en face avant 100a.

Après la gravure KOH, la réflectivité de la face avant (« F-100a après gravure) est plus élevée que celle avant gravure, mais reste inférieure à celle de la plaquette de référence non diffusée (et donc dépourvue de couche de PSG). Autrement dit, la gravure KOH réduit l'épaisseur de la couche de PSG située en face avant 100a, mais ne la retire pas complétement.

La technique de caractérisation ECV (« Electrochemical Capacitance Voltage ») est utilisée pour mesurer le profil de la concentration en dopants en profondeur d'une couche dopée. Elle peut donc permettre de vérifier l'intégrité de la couche de silicium dopé au phosphore située en face avant des plaquettes, malgré l'amincissement de la couche de PSG sus-jacente.

La figure 7 montre dans quelles zones de la face avant 100a et la face arrière 100b les mesures ECV ont été effectuées : une première zone 701 située au centre de la de la face avant 100a, une deuxième zone 702 située au centre de la face arrière 100b, une troisième zone 703 située en face arrière 100b à approximativement 10 mm de deux bords adjacents de la plaquette, et une quatrième zone 704 située en face arrière 100b à approximativement 1 mm des deux bords. La troisième et la quatrième zones 703-704 sont suffisamment proches des bords de la plaquette pour qu'on y trouve, d'après la figure 5, la deuxième couche d'oxyde 102b, ici en PSG.

La figure 8 représente la concentration en impuretés dopantes, atomes de phosphore (en ordonnées à gauche) ou atomes de bore (en ordonnées à droite), dans la deuxième zone 702 et dans la troisième zone 703 de la face arrière 100b. Pour la troisième zone 703, une mesure de la concentration a été effectuée avant l'étape S2 de gravure KOH et une autre mesure a été effectuée après cette étape S2.

Les relevés de concentration en impuretés dopantes de la figure 8 indiquent que seuls des atomes de bore ont été détectés dans la deuxième zone 702. Cela confirme qu'aucune diffusion du phosphore ne s'est produite au centre de la face arrière de la plaquette. Dans la troisième zone 703, on a détecté avant gravure une importante concentration en atomes de phosphore, signe que cette zone a été diffusée. Après gravure, les atomes de phosphore ne sont plus détectables. La concentration en dopants mesurée dans la troisième zone 703 est une concentration en atomes de bore. Autrement dit, la couche de silicium dopé au phosphore présente dans la troisième zone 703 a disparu pour laisser la place au silicium de la plaquette dopé au bore. Les mesures ECV confirment donc le résultat obtenu par les mesures de réflectivité, selon lequel le dopage résiduel en face arrière a régressé.

Dans certaines conditions de gravure, en particulier si le temps de gravure est trop court, la couche de PSG en face arrière 100b peut être entièrement retirée au niveau de la troisième zone 703 et n'être que partiellement retirée à proximité immédiate du bord de plaquette, dans la quatrième zone 704 (c'est dans cette zone 704 qu'elle est initialement la plus épaisse). Les mesures ECV ont en effet révélé la présence de phosphore dans la quatrième zone 704 après gravure.

Même dans ce cas de retrait partiel du dopage résiduel, le procédé selon l'invention procure des avantages significatifs, car la zone de la face arrière dépourvue de dopants est néanmoins élargie et l'état de surface de la face arrière est grandement amélioré. La face arrière de la plaquette pourra été isolée électriquement de la face avant, par exemple en supprimant le silicium dopé (ici au phosphore) dans la quatrième zone 704 par abrasion mécanique des bords de la plaquette ou en creusant un sillon par ablation laser à la périphérie de la face arrière. Comme indiqué précédemment, l'ablation laser pourra être mise en oeuvre plus facilement grâce à l'état de surface amélioré de la face arrière.

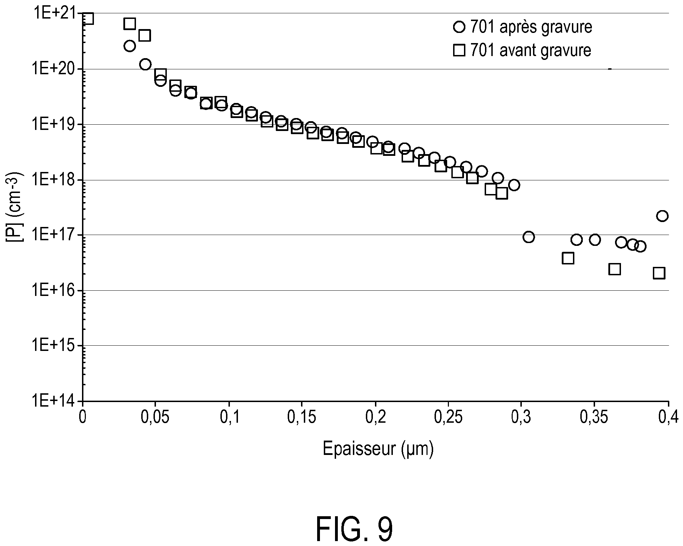

Enfin, la figure 9 montre que la concentration en atomes de phosphore mesurée dans la zone centrale 701 de la face avant 100a après gravure est quasiment identique à celle mesurée (dans la même zone) avant gravure. On peut en conclure que le dopage de la face avant 100a n'a pas été impacté par l'étape de gravure alcaline S2.

## Revendications

1. Procédé de dopage de plaquettes de silicium (100) présentant chacune une face avant (100a) et une face arrière (100b), comprenant les étapes suivantes :
- disposer (S1) les plaquettes de silicium dans une nacelle (120) en apposant leur face arrière (100b) contre une surface plane ;
- introduire (S1) la nacelle dans un four de diffusion (110);
- introduire (S1) dans le four de diffusion de l'oxygène et des impuretés dopantes d'un premier type de conductivité et diffuser thermiquement les impuretés dopantes en surface des plaquettes de silicium (100), d'où il résulte une première couche de silicium (101 a), dopée du premier type de conductivité et occupant toute la face avant (100a) de chaque plaquette de silicium, et une deuxième couche de silicium (100b), dopée du premier type de conductivité et située en périphérie de la face arrière (100b) de chaque plaquette de silicium, les première et deuxième couches de silicium étant recouvertes respectivement d'une première (102a) et d'une deuxième (102b) couches en oxyde de silicium dopé ;
- plonger (S2) les plaquettes de silicium (100) dans une solution alcaline (300), de façon à graver les première et deuxième couches (102a, 102b) en oxyde de silicium dopé et la deuxième couche de silicium (101 b).

2. Procédé selon la revendication 1, dans lequel la gravure (S2) des première et deuxième couches (102a, 102b) en oxyde de silicium dopé et de la deuxième couche de silicium (101 b) est effectuée dans des conditions telles que le rapport de la cinétique de gravure du silicium sur la cinétique de gravure de l'oxyde de silicium est compris entre 200 et 2000.

3. Procédé selon la revendication 2, dans lequel la solution alcaline (300) est une solution aqueuse d'hydroxyde alcalin portée à une température comprise entre 0 °C et 80 °C et présentant une concentration pondérale en hydroxyde alcalin comprise entre 5 % à 45 %.

4. Procédé selon l'une quelconque des revendications 1 à 3, dans lequel la solution alcaline (300) est choisie parmi une solution aqueuse d'hydroxyde de lithium (LiOH), une solution aqueuse d'hydroxyde de potassium (KOH), une solution aqueuse d'hydroxyde de sodium (NaOH) et une solution aqueuse de tétraméthylammonium hydroxyde (TMAH).

5. Procédé selon l'une quelconque des revendications 1 à 4, dans lequel les plaquettes de silicium (100) sont réparties par paire dans des fentes réceptrices (121) de la nacelle (120), en accolant leurs faces arrière (100b) l'une contre l'autre.

6. Procédé selon l'une quelconque des revendications 1 à 4, dans lequel les plaquettes de silicium (100) sont posées à plat sur une plateforme de la nacelle (120).

7. Procédé selon l'une quelconque des revendications 1 à 6, dans lequel les plaquettes de silicium (100) sont initialement dopées d'un second type de conductivité opposé au premier type de conductivité.
